Europäisches Patentamt

(19) European Patent Office

Office européen des brevets

(11) Publication number: **0 196 631**
**A2**

(12) # EUROPEAN PATENT APPLICATION

(21) Application number: **86104252.1**

(22) Date of filing: **27.03.86**

(51) Int. Cl.⁴: **H 03 F 3/195**
**H 03 F 1/48**

(30) Priority: **01.04.85 CN 85100523**

(43) Date of publication of application:
**08.10.86 Bulletin 86/41**

(84) Designated Contracting States:
**DE FR GB**

(71) Applicant: **Zhiwei, Yu**
**No. 1, 92th Lane Yongnian Road**
**Luwan District Shanghai(CH)**

(72) Inventor: **Zhiwei, Yu**
**No. 1, 92th Lane Yongnian Road**
**Luwan District Shanghai(CH)**

(74) Representative: **Müller, Hans-Jürgen, Dipl.-Ing. et al,**
**Müller, Schupfner & Gauger Lucile-Grahn-Strasse 38**
**Postfach 80 13 69**
**D-8000 München 80(DE)**

(54) Integrable high frequency, wide band and superlinear amplifier and its fabrication.

(57) An integrable, high frequency superlinear amplifier and its fabrication method. Which belongs to the basic amplifier fabrication field related to the negative feedback and signal conversion.

The adoption of such methods as compromising and the separation of integration may solve the problems in technology like the complication in Kβ design, the large quantity of elements, and the difficulties in integration, generalization, the serialised and universal design and fabrication.

The amplifiers have following advantages: high frequency, wide band, superlinera, high stability, integration, high reliability, low noise, antigravitation, serialised and universal fabrication, and adjustable impedance without a transformer.

It may be used digital pulse amplification and transformation near 10GHZ, in meters, automation, video and audio frequencies, telecommunication systems, fiber optic systems, active analogue computation, and in other cases which call for high requirements such as military and aerospace uses.

Integrable High Frequency, Wide Band and
Superlinear Amplifier and Its Fabrication

This invention relates to an integrable high frequency,
wide bandwidth and superlinear amplifier and its fabrication method. It deals with high frequency, wide bandwidth, high stability, low noise, high reliability, deep
negative feedback and improvement of the technology of
integration. The amplifier also may be applied to a weak
feedback or a D.C. and audio circuits.

If the above characteristic is fulfilled and transformer
is not used, the impedance of such amplifier could be
adjusted to desirable values. With this invention, a series
of universal integrated fundamental amplifier could be
designed and fabricated.

Present state-of-arts of this technology

In order to make an amplifier with better performance,
such as high frequency, wide bandwidth and superlinearity
or stability in the parameters, deep feedback is generally
used. However, two serious problems would occur: first,
the design for a high frequency and deep feedback amplifier
becomes more complicated; for example, a line amplifier
with bandwidth of 0.3 MHZ--9MHZ has more than 50 K correcting elements, in which standard Bode method is used.
Because there are many elements, it is not possible to make those parameters of the elements completely consistent, and also it is difficult to control parasitical parameters. Besides, precise elements are required. Due to the above mentioned facts, it is hard to integrate an amplifier with high performance into integrated circuit. Secondly, reverse bias isolation is generally used in integrated circuits. However, both isolation capacitance and parasitical inductance are large. Thus, the parasitical parameters are not easily and effectively controlled, and any additional phase shift must be considered for a high frequency circuit.

Those amplifiers are usually fabricated by discrete elements or hybrid integration with thick and thin film technics. Therefore, each amplifier must be carefully designed and adjusted, and the rate of products to meet the specification are less than 10 % in one batch process. It is very difficult to fabricate in mass and integration production. Also, it is impossible to produce a series and universal integrated amplifier with high quality, or to provide a simple design for such amplifier with high productivity, which could be constructed by discrete elements.

It is expected that a high frequency (or low frequency) wide band superlinear amplifier with simple design, less correcting elements, better stability independent of transistors' characteristics, small additional phase shift, less cost and integrated circuits will be widely applied to amplification for analog signals and PAM, PCM signals, precise and high speed automation system, communication system, military and aerospace equipments and audio music systems.

Up to date for application, no high frequency wide band superlinear, universal series integrated products and its fabrication method explained in this invention has been found. For example, US-PS 3 774 118, 3 530 392, 2 959 741, 2 885 494 etc. have not proposed any simplified design method for $K\beta$ design and new methods for integration. Particularly, no idea for an universal and serialised design and production with discrete and integrated elements has been provided.

## The objects of the invention

The objects of this invention are to simplify the design of circuits and propose a new fabrication method for integration to produce universal and serialised integrated circuits with many advantages, such as high frequency, wide bandwidth, superlinearity, high stability, low noise, high reliability and deep feedback (or weak feedback), which will be widely used in many areas. Therefore, it has overcome many disadvantages in the existing techniques, such as difficulties for adjustments and integration, etc. There are two types for the circuit design: two-stage amplifier and three-stage amplifier. If this invention is applied to an audio system, it would posses many advantages: such as low modulation distortion, low transit distortion, negative feedback about 180° and utilization of transistors with low characteristic frequency. There are two main new ideas in this invention. First, the circuit dsign could be simplified and the number of correcting elements could greatly be reduced (for example, 1-7 elements needed). Secondly, a new integration method for fabricating the invented amplifier is proposed. If these two new ideas are applied, the amplifier produced could work at about 10 GHZ or down to D.C. frequency. The new integration technology used in this invention mainly adopts separation method, in which the total of the feedback circuit length is approximately equal to the size of the silicon chip or smaller than that size in order to reduce the parasitical capacitance, inductance of ground wires and spacial induction to the least extent. The design of circuits, mentioned in this invention utilizes basically two-narrow-one-wide of two-wide-one-narrow method combined with Bode method. The design of this invention presents a new method with least number of correcting elements. The new integration method for fabrication and the method controlling parasitical parameters of discrete elements have guaranteed the implementation of above circuits. In this invention the Bode method, two-wide-one-narrow, two-narrow-one-wide method may respectively combine with the above mentioned integration techniques or the control method for discrete elements. Because deeper negative feedback is applied, specifications, such as harmonics distortion and stability of the invented amplifier may improve to a factor of $(1+K\beta)$, depending on feedback intensity. The invented amplifier is a basic amplifier, and it could be cascaded for consecutive multistage multiplication.

Detailed measures and methods used in the invention:

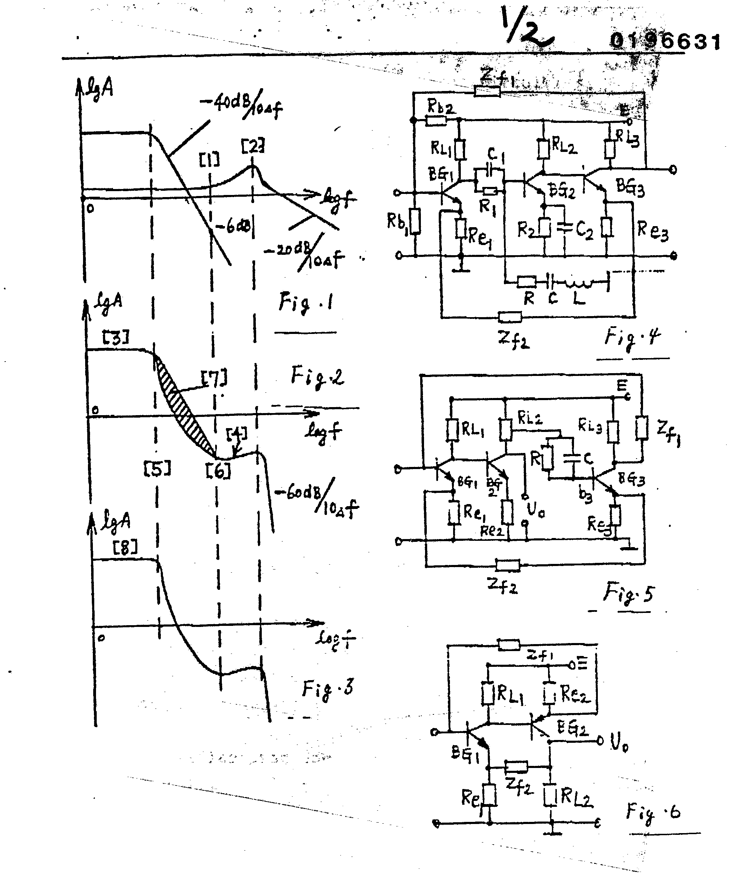

1. Three-stage type with discrete elements: Compromise between two-narrow-one-wide method and Bode method is used. (In order to improve the performance two-narrow-one-wide method, two-wide-one-narrow and Bode methods may respectively combine with the following integrated circuit techniques or control method for descrete elements). The key points of compromise design are the following: first, the bandwidth of the amplifier with widewidth must meet following requirements: If the gain curve for two narrow bandwidth stages passes corresponding frequency through 0 point to 6dB as shown in Fig. 1 [1], the peak point, as shown

0196631

in Fig. 1 [2], of the enhancing curve with single capacitor for wide bandwidth stage should be ahead of
above frequency [1]. Therefore the resulting curve
of three stages (see Fig. 2 [3]) below the 0 point
is approximately flat (Fig. 2 [4]). Then, the shadow
section shown in Fig. 2 [7] by dash lines should be
removed at the -40dB/10 f descending slope, which is
shown in Fig. 2 between [5] and [6]. A $R_3L_3C_3$ network
is used to absorb the dash area section. The above
single capacitor enhancement method is implemented
with $R_1C_1R_2C_2$ shown in Fig. 4 or with RC in Fig.5.
Through these two steps, the resulting three-stage
curve approaches the least Bode phase shift curve (Fig.
3 [8]. In order to reach more precise correction or
deeper feedback, more correcting elements can be incorporated into Fig. 4 and Fig. 5 according to Bode
method. That can make the resulting curve further
approach ideal curve. For example, the frequency [5]
in Fig. 2 is enhanced to be a prominent point (with
RLC serial enhancement network), and other frequencies
in Fig. 2Z over and above [6] can be enhanced with a
single capacitor correcting or RLC enhancement network.
However, if the bandwidth of wideband stage is sufficiently large and the parasitical parameters are well
controlled, the further precise correction above is
not required, and only $R_1C_1$ or $R_2C_2$ are needed.
Then, it should be considered whether it is necessary
to remove dash area section in Fig. 2 [7] by $R_3L_3C_3$.
If $R_3L_3C_3$ are not used, this circuit becomes the same
one as designated by the name of two-narrow-one-wide
or two-wide-one-narrow method. The wide bandwidth stage
can be designed at any stage. If $R_2C_2$ are used to in-
crease the bandwidth, the increasing coefficient of
bandwidth is $(1+ K\beta)$. In order to reach the above purpose, calculated and experimental curves are usually

- 6 -

0196631

plotted in a double logarithum plotting paper in design, and frequency [2] for wide-bandwidth stage and the dB increment at [2] are then determined. The increment at frequency [2] is usually 3-26 dB. The more the increment, the less the phases shift at [1]. The amplitude of increment is determined by $R_1C_1$ or $R_2C_2$ in Fig. 4. $Z_{f1}$, $Z_{f2}$ play a role of current and voltage feedback, and adjust the impedance to the desired value. The feedback type with three stages only absorbs a little input and output signals. It is good for low noise and low distortion. The highest frequency of around transistor 0.9 $f_T$ can be employed in this design.

2. Modified three-stages type:

If the output is connected to collector for second stage (Fig. 5), the wide bandwidth stage for enhancing and widening frequency range should be at third stage. This stage is specialized in negative feedback conversion, and its feedback intensity is determined by $R_{e3}$ and $R_{L3}$ or the different tapped points at $R_{L2}$. But $R_{e3}$ mainly specifies bandwidth of $BG_3$, and the peak point of enhancement [2] is determined by RC in Fig. 5. The feature of this method is to make the bandwidth of wide bandwidth stage reach to maximum value. This is due to the fact that third stage is a feedback attenuation stage, and larger $R_{e3}$ can be used. According to the feedback of this stage, bandwidth increases to a factor of $(1+ K\beta)$, for example, frequency [2] can reach to (0.5-1.0) $f_T$. If increases, frequency [2] can increase too. The advantage for modified three-stage type is that the operating frequency is higher than three-stage type, for example, it can reach to about (0.9-1.0)$f_T$. Gain, feedback, noise figure and harmonic distortion all are better than the following two-stage type.

3. Two-stage type:

Shortcomings for usual two-stage type are that its impedances can not be adjusted, open-loop gain is low and noise figure and harmonic distortion are poor. In this invention NPN and PNP transistors are mixed together and both current and voltage feedback are used (Fig. 6). Feedback points for $Z_{f1}$, $Z_{f2}$ can be moved upon $R_{e2}$ $R_{L2}$ taps to adjust required output and input impedances. If some suitable cases, $Z_{f2}$ can be cancelled and shorted out, and $R_{e1}$ and $R_{L2}$ are merged into one resistance. This resistance specifies current-series feedback. Thus, it improves the open-loop gain, noise figure and harmonic distortion. Its drawbacks are that specifications, such as gains, etc. are not as good as three-stage type and modified three-stage type. Because influences of $R_{e1}$ $R_{e2}$ existing in open loop are larger than above three-stage and modified three-stage type, gain is lower than those two circuits.

All these above three design methods introduce noise less than 0.5-6 dB and can adjust impedances. Even without transformers, all above mentioned excellent performances can be obtained. It is very important for integration and miniaturisation.

If the peak point is enhanced by 3-26 dB with RC at the frequency [5] in Fig. 2, phase shift can be controlled within approximate minus 180° in the bandwidth used, and additional phase shift is in the range of 0° - 5°. Because various instantaneous music waveforms include high-order harmonics, and the loudspeaker's reserve electromotive forces and burst stopping voltage also have high frequency components, this amplifier can ensure approximate 180° negative feedback with 0°-5° additional phase shift for these high frequency components. Thus, it improves a variety of instantaneous characteristics. Meanwhile, transistors employed require lower $f_T$ than that by conventional design. It, then, results in low cost. This method can be applied to two-stage, three-stage and multistage circuits.

4. Fabrication for integrated circuits:

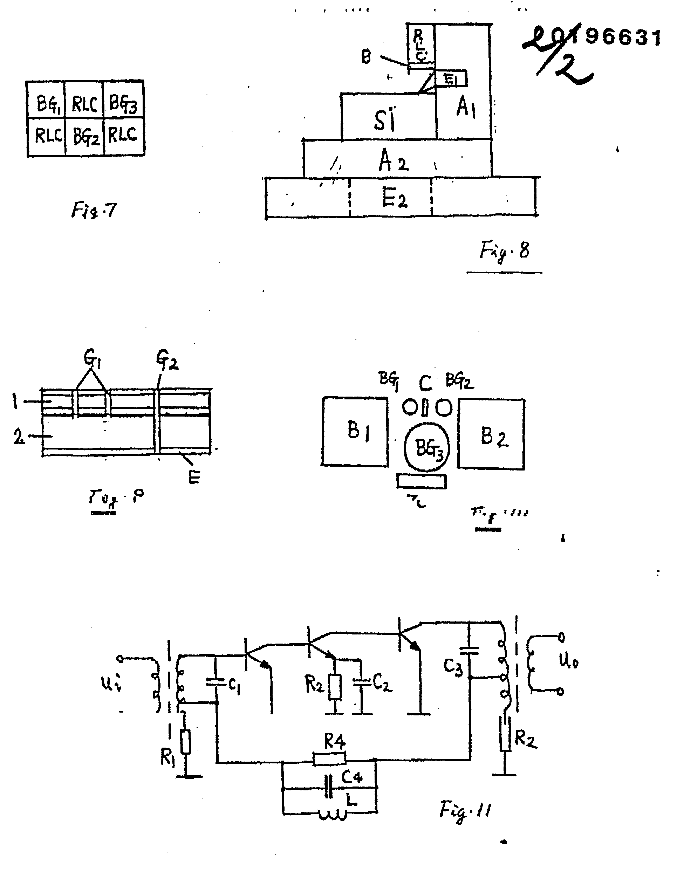

According to the above analyses, the following configurations for integrated circuits have been devised (Fig. 8). It ensures all the connecting wire length for electrodes within 0.01-0.5 mm. The wire length from emitter must be as short as possible to avoid . additional phase shift. The sharp edges of ground wire $E_1$ reduces inductance from the ground wire on the silicon ship. If there is no direct ground, the sharp edges contacts can be omitted. Meanwhile, the height for $E_1$ is reduced, and it is good for further reducing the connecting wire. $A_2$ is a ceramic heat sink, and $A_1$ is a ceramic substrate for fabricating ground wire $E_1$ and film R, L, C. In order to close to other silicon chips R, L, C should be at the top upper part of $A_1$. $A_1$, $E_1$, RLC are glued together, based on $A_1$ and prefabricated separately, and all of them are adhered to $A_2$. B is the soldering pont for R,L,C with silver coating. The thickness of $E_1$ and its distance from silicon chip have influences on the length of all connecting wire and parasitical capacitance between the ground and the silicon chips. Meanwhile, in order to reduce the inductance of ground wire, $E_1$ should

be made thinner and wider, for example, $E_1$ with thickness of 0.01-0.2 mm and width of 1-6 mm. Thus, the ground wire inductance is less than conventional integrated circuits and parasitical capacitors also are very small. The silicon chip is square or rectangular in shape. After being fabricated on the whole circular chip successfully, a small portion is cut off from chip, which contans three transistors. RLC may be integrated and fabricated first, and they are then soldered on $A_2$. Later, transistors and RLC are separated from requirements. Therefore, individual parasitical parameters are obtained with least distance and fabrication exploits integration techniques. Because the size of silicon chip depends on transistors, the total length of loop may be controlled by less than 0.1-10 mm, which is less than or approximately equal to the size of silicon chip. If inductionless capacitors are used, the virtual total length is much more shorter. In case of special requirements or generalization needed, manufacturer may leave rooms for RLC, where customers may put various film-elements on the top of integrated circuits themselves or they may ask manufacturer to fabricate in customer design way. Manufacturers may develop a variety of RLC chip elements and publish products' manual to spreed applications. The above integrated circuits with each parasitical capacitor of less then 0.01-50 pF can be fabricated together first and then separated (Fig. 7). It is allowed to punch holes on $E_2$ to reduce parasitical capaciters.

By the above mentioned design, each transistor has optimal independent parasitical parameters, and it fabrication employs integrated techniques. Thus, it is good for mass production. Drawbacks, such as reverse-bias isolation capacitor and other large parasitical parameters, by conventional integrated circuits are eliminated. Because modern soldering is precise and very fast, the design of this invention ensures precise geometrical sizes. In order to improve reliability, the defective sections in chips may be removed by a computer-controlled location detecting method.

5. Amplifier with discrete elements and its fabrication:

If integrated techniques are not available, it is very simple and easy to employ the design of this invention. And also its performances are better than existing known techniques. First, three-layer printed circuit boards are used (Fig. 9) (two-layer printed circuit boards may also be used). The upper and lower layers are of copper foil, $G_1$ is a metallized hole, which prevents soldered elements from pulling out. Third layer mainly serves as a ground wire. If grounding is needed, it must be connected to the large area ground wire on third layer. However, the first fiber board should be thin, and all interconnections should be on the first layer. A few wires may be laid on second layer, but the circular soldering joints should be small and the second fiber board is thick in order to make parasitical capacitance small enough and ground inductance small enough too. If the requirement for tensile strength is not serious, two-layer board can be used. Now the arrangements for elements are considered (Fig. 10). Transistors, emitter capacitance and feedback capacitors which have influences on A.C. loop length, are laid between two transformers, where the interval between transformers is about 3-20 mm, and all other resistances are laid outside the transformer. Thus total loop length is controlled within 10-65 mm. Ground wires here are considered to be an inductionless ground wire, and it can eliminate additional phase shift, which is very important. Multiple-wire of 0.05-0.3 mm each are parallelly wound and interleaved, and all layers are interlaced with each other to obtain small parasitical capacitance and leak inductance in transformers.

Advantages of the invention over known techniques:

$K\beta$ design is greatly simplified; correcting elements greatly reduced; and no precise elements are required; design and fabrication become convenient; fabrication can exploit integrated techniques; parasitical parameters can be well controlled; process technology becomes simple; Because of simplified design, small number of elements and integration, it is convenient to produce serialised, universal and low-cost integrated products or discrete products used in various fields; products may obtain many excellent characteristics, such as high frequency, wide bandwidth, superlinearity, high stability, high reliability, low noise, antigravitation integration and adjustable impedance under no transformers.

If frequency used is lower, the circuit design of this invention combined with conventional integrated circuit process techniques may be used or conventional design combined with separation method of this invention and integrated techniques may be employed.

Because of the above mentioned advantages the amplifier may be applied to various systems as follows:

If it is used to amplify impulse digital signals, various characteristics, such as low noise, adjustable impedance and high frequency, etc., are obtained, especially, ad-

- 12 -

justable impedance may improve reflecting and standing waves' characteristics. If switch control circuits are inserted to feedback loop or input and output terminals, analog signals may be converted into PAM signals. Because the amplifier can operate at high frequency, it can be served as a fast processing for other digital circuits.

If it is used in products with high requirements, such as instruments, automation control, military and aerospace technology, various advantages of the amplifier, such as integration, miniaturization, antigravitation, high frequency, widebandwidth, superlinearity, high stability, low noise and adjustable impedance without transformers are exploited.

When the amplifier is applied to analog operation and active filters, characteristics as low noise and high frequency are employed.

When it is applied to emitting and receiving equipments for broadcast and television, superlinearity is used to solve distortion problem. In addition, no matter how AGC voltages change the passband characteristics remain invariant in AGC adjustment for fixed impedance. Thus, it can improve performances of present various emitters, receivers, televisions and radio receiver circuits. This is because amplifier directly change gain through controlling the magnitude of feedback impedance. Meanwhile, introduced noise figure is less than 3 dB.

When it is applied to an audio system, such as receivers, amplifiers, tape recorder, for domestic and professional equipments, low cost and the following better characteristics are obtained. This is because of lower $f_T$ and moderatenlinear transistors are used in this invention to obtain low harmonic distortion, intermodulation distortion and fast instantaneous distortions. If it is operated in the range of 0.1--0.6 prominent peak frequency, only 0--10° additional phase shifts are introduced by raising peak [5] outside passband to 3--26 dB. It ensures approximate 180° negative feedback for audio-high frequencies, and demonstrates very fast response speed. Even for burst stopping music waveforms and loudspeaker's reverse electromotive forces, which have rich high frequency components, they can be sufficiently fast suppressed. Therefore, not only circuit problems but also the match problems between loudspeakers and amplifiers interfaces as well have been solved. There is lower requirements for transistors.

When it is applied to communication systems, because the amplifiers of this invention have excellent linearity and impedance adjustability with no transformers, more than 90 % of transformers may be eliminated in voice terminals and line terminals bays. Devices for modulators are available from markets now, and carriers distribution and concentration all employ active distributors. Any characteristics required, such as, constant current output (high impedance), low resistance concentration, which improve concentration accuracy and reflection performances, can be obtained. In order to reduce volume, single crystal chip filter may be used. Thus, the amplifier is needed to work at about 10 MHz. However, simple and high frequency performance of this invented amplifier may easily meet the requiremens. FET of $V_{gs}$ of 1200 V are used in balance inputs, and high-voltage transistors or high-power and high-voltage FET are employed in balanced outputs. Integrated circuits are divided into blocks according to bays.

When the amplifier is applied to optical fiber systems, characteristics, as simplicity, integration, low noise and low cost, are more attractive. Especially, in optical fiber analog systems, various above good performances, as simplicity, effectiveness, superlinearity and high frequency, are shown.

## Description for related figures:

Fig. 1 - Fig. 3 are schematic diagrams of curves for two-narrow-one-wide and Bode methods. In Fig. 1 curve with -40 dB/10 f demonstrates one for two-narrow stage, and curve with -20 dB/10 f expresses characteristic for wideband stage. Frequency [2] is the enhancing peak. When it is used in audio circuits, frequency [5] corresponds enhancing peak for narrow band stage.

Fig. 4 is three-stage configuration.

Fig. 5 is modified three-stage configuration.

Fig. 6 is two-stage configuration. $R_1, C_1$; $R_2 C_2$ are enhancing elements for peak in Fig. 4, and RLC are absorbing network for shadow section (7), $Z_{f1}$, $Z_{f2}$ are feedback impedances.

Fig. 7 is a schematical diagram for integrated separation method.

Fig. 8 is a schematic diagram for hybrid integrated-film fabrication. Silicon chip is separated as in Fig. 7.

Fig. 9 is a schematic diagram for three layers. First layer of fiber board is designated by 1; and second fiber board is designated by 2.

Fig. 10 is a diagram for arrangement of discrete devices.

Fig. 11 is a schematic diagram for an amplifier with trans-
formers and discrete elements. $R_2$ $C_2$ are used to enhance
for wideband stage; $R_4$ $C_4$ L are feedback impedance:
$r_1$ $r_2$ are resistances for adjustment; $C_1$ $C_3$ are capa-
citors for phase raising of transformers.

## Descriptions for implementation examples:

1. Circuits in Fig. 9, 10 and 11 are explained here.
$R_2$ $C_2$ in Fig. 11 are used to enhance peak for wideband stage, whose bandwidth is 0.08 MHz--5MHz and whose
high frequency gain is 44 dB. Its feedback deepness
is 45 dB at low frequency and 14 dB at high frequencies.
At low frequency $b_{20}$ is 80 dB; $b_{30}$ is 105 dB; at high
frequency $b_{20}$ is 80 dB, $b_{30}$ is 94 dB. It satisfies the
requirements of linearity. Its impedance is 75$\Omega$. Re-
flection attenuation in full bandwidth is less than
27 dB. In this example layout is shown in Fig. 10.
The distance between two transformers is 12 mm; tran-
sistors $C_2$, $C_4$ are laid between the transformers, and
other elemens independent of loop length all are laid
outside. Because one of three layers with ground wires
of large area is inductionless, total loop length is
limited within 35 mm to reduce the effect of additional
phase shifts. Transformers are wound with double-line
interleaved and each layer in parallel connection by
0.05--0.3 wires. Its parasitical capacitances are less
than 10 pF and leakage inductance is less than 0.1 %
to guarantee stable edges. Passband characteristics
are ensured by $R_4$, $C_4$, L. If R is substituted for $R_4$,
$C_4$, L, gain curve becomes flat. In this example gain curve is a slant one with 26 dB at low frequencies and 44 dB at high frequencies.

2. When the circuits of this invention are designed to work at several GHZ, resistances are limited within 1 k$\Omega$, and most of them are limited to 10--500$\Omega$, except those bias resistances with less influences of A.C. parameters. For example, in Fig. 4, operating frequency is at 1 GHZ, and $f_T$ for three transistors are 4 GHZ. Therefore, =4, $K_i$ for second stage reaches to 0.5 and the original $K_i$=4. Thus (1+K$\beta$)=4/0.5=8, i. bandwidth increases to a factor of 8, reach to 16-20 GHZ. Looking up the logarithman gain curves, two-narrow stages has descending rate at -40 dB and 0 dB corresponds to 4.4 GHZ; -6 dB corresponds to 5.6 GHz; -10 dB corresponds to 40 GHZ; -20 dB coresponds to 70 GHZ. It is demonstrated that if feedback safeguarding extent is 6 dB, 5.6 GHZ wideband stage mapprocches requirements for design. Therefore (1+K$\beta$)=(30-28)/20=1.5 for wideband stage is enough. In order to ensure stability, bandwidth for second stage is devised to 80 GHZ., then (1+K$\beta$)=4 and therefore Ki for second stage equals to 1 (Ki=1), enhancing peak is set at 80 GHZ. When $R_s$= $R_L$=50, $K_v$=24 dB. If feedback at high frequencies is 7 dB, and feedback at low frequencies is 35 dB, $b_{20}$= 50 dB, $b_{30}$=70 dB for transistors, flat gain 17 dB for amplifier is obtained with $b_{20}$=85 dB and $b_{30}$=105 dB at low frequencies and $b_{20}$=57 dB, $b_{30}$=77 dB at high frequencies.

In Fig. 5, because third stage serves as a wideband stage and may be a negative gain, the bandwidth can be made very large. The emitter of second stage may directly be grounded. Thus, total feedback is larger than the circuit in Fig. 4 an it may operate at higher frequencies. When circuit in Fig. 6 is used, because

of $R_{e1}$, $R_{L2}$. $R_{e2}$ resistances. Open-loop gain is lower and feedback is limited. If circuit in Fig. 6 is used, $K_{vf}=8$ dB, $b_{20}=60$ dB, $b_{30}=80$ dB at low frequencies. This is the reason why we recommend three-stage configurations of this invention. As to the gain adjustment, it is controlled by $Z_{f1}$, $Z_{f2}$. If higher gain is needed multistage cascaded multiplication coith above configurations a basic stage will be satisfied. Above mentioned circuits under same conditions at 10GHZ obtain $K_v$ about 10 dB. Under high frequencies $K_v$ gan reach to 10-20 dB is considered as a very large value.

This example is fabricated by integrated separation methods, shown in Fig. 7 and Fig. 8. Loop length is 1.5 mm and the introduces Cob is less than 0.1 pF. Methods shown in Fig. 7 and Fig. 8 can be combined to fabricate, for example, RLC in Fig. 7 is fabricated by thick and thin film methods, and Si in Fig. 8 may employ separation configuration shown in Fig. 7.

Claims

1. A method of producing a kind of high frequency, wide band, superlinear amplifier characterized in that it comprises a compromise method of $K\beta$ correction and an integrated circuit separation technology and can be serialized and universal with best performance, which can be integrated, with high frequency, wide band, superlinearity, low noise, high reliability, the said compromise method or said separation technology can be utilized alone, or combined with the prior technology.

2. Method according to claim 1, wherein the said separation technology is firstly integrated in manufacture, then the parasitical parameters are controlled by the said separation method while the precise soldering is securely fulfilled.

3. Method according to claim 1 or 2, wherein the R.L.C. is produced with ordinary film or integrated production, follow separation and welding.

4. Method according to any of claims 1 - 3, wherein the heat dissipation plate E is holed.

5. Method according to any of claims 1 - 4, in which the feedback impedance and adjustable impedance etc. is set on the top of the integrated circuit.

6. Method according to any of the claims 1 - 5, wherein the amplifier can be fabricated with the method of two-narrow-onw-wide, to-wide-one-narrow, Bode and compromise for other similar methods, and their hybrid combination.

7. Method according to any of claims 1 - 6, wherein the length of the feedback loop is set approximately equal to or lesser than the size of the semiconductor chip.

8. Method according to any of claims 1 - 7, wherein with the computer location detecting method, the part of those having defects on the chip is deleted.

9. Method according to any of claims 1 - 8, wherein, the diameter of the wire is selected 0.05 - 0.3 mm, upon the transformer is used.

10. Method according to any of claims 1 - 9, wherein, for the printed circuit board, the multiple layered board is used and one of which mainly serves as large area ground wire.

11. Amplifier produced in accordance with any of claims 1 - 10.

Fig·1

Fig·2

Fig·3

Fig·4

Fig·5

Fig·6

Fig·7

Fig·8

Fig·9

Fig·10

Fig·11